# EUROPÄISCHE PATENTANMELDUNG

(11) **EP 2 398 123 A2**
(43) Veröffentlichungstag der Anmeldung: **21.12.2011**
(21) Anmeldenummer: 11169232.3
(22) Anmeldetag: 09.06.2011
(51) Int. Cl.: H02H 5/00, H01L 31/02

(54) **Verfahren und Sicherheitsschaltung zum Betreiben einer Photovoltaikvorrichtung**

(30) Priorität: 15.06.2010 DE 102010023761
(71) Anmelder: Ritter Elektronik GmbH, 42897 Remscheid (DE)
(72) Erfinder: Baader, Uwe, 42111 Wuppertal (DE)
(74) Vertreter: Kahlhöfer, Hermann

(57) **Zusammenfassung**

Die Erfindung betrifft ein Verfahren und eine Sicherheitsschaltung (1) zum Betreiben einer Photovoltaikvorrichtung (2). In einem ersten Betriebszustand wird der von der Photovoltaikvorrichtung (2) erzeugte Strom kurzgeschlossen und in einem zweiten Betriebszustand wird der von der Photovoltaikvorrichtung (2) erzeugte Strom über Energie übertragende Leitungen (5) einem Verbraucher (12) zugeführt. Ein Steuersignal zur Steuerung des Betriebszustandes wird über die Energie übertragenden Leitungen (5) übermittelt, wobei zur vorzugsweise zur Aufrechterhaltung des zweiten Betriebszustands das Steuersignal permanent übermittelt werden muss.

Durch die Erfindung ist es möglich, ohne eine zusätzliche Steuerleitung Photovoltaikvorrichtungen 2 bei Bedarf kurzzuschließen, um die Photovoltaikvorrichtungen in einen sicheren Zustand zu überführen. Die erfindungsgemäße Sicherheitsschaltung 1 sorgt zudem dafür, dass wegen eines nur geringen Spannungsabfalls im Kurzschlussfall einfache und kleine Elektronikbauelemente verwendet werden können, die trotz geringer Kurzschlussspannung über eine Spannungserhöhungsvorrichtung mit einer genügend hohen Sperrspannung versorgt werden, und dass während der Montage keine gefährlichen Spannungen vorliegen. Die Erfindung ermöglicht somit jederzeit eine sichere Handhabung von Photovoltaikvorrichtungen.

## Beschreibung

Die Erfindung betrifft ein Verfahren und eine Sicherheitsschaltung zum Betreiben einer Photovoltaikvorrichtung. Eine Photovoltaikvorrichtung erzeugt in Abhängigkeit von einfallendem Licht elektrischen Strom. Typischerweise wird in einem ersten Betriebszustand der von der Photovoltaikvorrichtung erzeugte Strom sicherheitshalber kurzgeschlossen und in einem zweiten Betriebszustand der von der Photovoltaikvorrichtung erzeugte Strom über Energie übertragende Leitungen einem Verbraucher oder Wechselrichter zugeführt.

Durch eine elektrische Reihenschaltung von Solarzellen in einer Photovoltaikvorrichtung erzeugt die Photovoltaikvorrichtung schon bei geringer Bestrahlungsintensität relativ hohe Spannungen. Diese Spannungen können einige 100 Volt betragen. Die hohen Spannungen liegen insbesondere auch dann vor, wenn noch kein Verbraucher an die Photovoltaikvorrichtung angeschlossen ist. Bei der Montage der Photovoltaikvorrichtung kann es somit zu Gefährdungen der Monteure kommen, wenn nicht der erste, kurzgeschlossene Betriebszustand vorliegt.

Die hohen Spannungen stellen auch z. B. bei einem Brand, auch wenn er nicht durch die Photovoltaikvorrichtung ausgelöst wurde, eine Gefährdung für Helfer und Feuerwehrleute dar. Die Feuerwehr stellt zwar routinemäßig bei einem Brand die Stromzufuhr zu einem Gebäude ab, dies betrifft allerdings nur einen eventuell der Photovoltaikvorrichtung nachgeschalteten Spannungswechselrichter. Die von der Photovoltaikvorrichtung erzeugte Spannung stellt somit weiterhin eine Gefährdung dar.

Üblicherweise befinden sich Sicherungsvorrichtungen zum Kurzschließen den Photovoltaikvorrichtungen zugeordnet auf einem Dach, während sich ein Spannungswechselrichter oder ein Verbraucher entfernt davon in einem Gebäude befindet. Der von der Photovoltaikvorrichtung erzeugte Strom wird somit über Energie übertragende Leitungen zu dem Spannungswechselrichter geführt, so dass die von der Photovoltaikvorrichtung erzeugten hohen Spannungen selbst nach einer Abschaltung der externen Stromversorgung auch innerhalb eines Gebäudes vorliegen können.

Es ist daher bekannt, den von der Photovoltaikvorrichtung erzeugten Strom bzw. Spannung über einen niederohmigen Widerstand im Bedarfsfall kurzzuschließen, so dass nur noch eine geringe Restkurzschlussspannung bestehen bleibt. Aus der DE 10 2008 052 037 B3 ist beispielsweise bekannt einen mechanischen Schalter vorzusehen, der durch ein druckbeaufschlagtes Medium einzelne Solarmodule kurzschließt. Aus der DE 10 2005 018 173 B4 und der DE 10 2007 048 914 A1 sind zudem Halbleiterbauelemente bekannt, die als Schalter im Bedarfsfall Solarmodule kurzschließen. Die für die Versorgung solcher Bauteile notwendige Spannung erlaubt es aber nicht, eine sehr niedrige Restkurzschlussspannung einzustellen.

All diese Konzepte benötigen allerdings zusätzliche Steuerleitungen und zum Teil auch eine eigene Energieversorgung, um ein Signal zum Kurzschließen an eine Photovoltaikvorrichtung zu übermitteln. Dies ist aufwendig, insbesondere wenn bereits installierte Photovoltaikvorrichtungen nachträglich mit einer Sicherheitsvorrichtung versehen werden sollen.

Aufgabe der Erfindung ist es daher, die mit Bezug auf den Stand der Technik geschilderten Probleme zumindest teilweise zu verringern, die Inbetriebnahme einer Sicherheitsschaltung für Photovoltaikvorrichtungen zu vereinfachen und ein sicheres Kurzschließen der Photovoltaikvorrichtung im Bedarfsfall zu ermöglichen.

Diese Aufgaben werden gelöst mit einem Verfahren und einer Vorrichtung gemäß den Merkmalen der unabhängigen Patentansprüche. Weitere vorteilhafte Ausgestaltungen der Erfindung sind in den abhängig formulierten Patentansprüchen angegeben. Es ist darauf hinzuweisen, dass die in den abhängigen Patentansprüchen einzeln aufgeführten Merkmale in beliebiger technologisch sinnvoller Weise miteinander kombiniert werden können und weitere Ausgestaltungen der Erfindung definieren. Darüber hinaus werden die in den Patentansprüchen angegebenen Merkmale in der Beschreibung näherer präzisiert und erläutert, wobei weitere bevorzugte Ausgestaltungen der Erfindung dargestellt werden.

Insbesondere wird die Aufgabe durch ein Verfahren zum Betreiben einer Photovoltaikvorrichtung gelöst, wobei in einem ersten Betriebszustand der von der Photovoltaikvorrichtung erzeugte Strom kurzgeschlossen wird und in einem zweiten Betriebszustand der von der Photovoltaikvorrichtung erzeugte Strom über Energie übertragende Leitungen einem Verbraucher zugeführt wird, wobei ein Steuersignal zur Steuerung des Betriebszustandes über die Energie übertragenden Leitungen übermittelt wird.

Unter einer Photovoltaikvorrichtung sind ein einzelnes Solarmodul oder auch eine Mehrzahl von zusammengeschalteten Solarmodulen zu verstehen, so dass entweder jedes Solarmodul einzeln oder eine Mehrzahl von Solarmodulen gemeinsam kurzgeschlossen werden kann. Zum Kurzschließen wird der von der Photovoltaikvorrichtung erzeugte Strom in dem ersten Betriebszustand über eine niederohmige Verbindung von einem ersten Anschluss der Photovoltaikvorrichtung zu einem zweiten Anschluss der Photovoltaikvorrichtung geführt.

In dem zweiten Betriebszustand wird der von der Photovoltaikvorrichtung erzeugte Strom über geeignete Kabel einem Verbraucher zugeführt. Der Verbraucher kann eine Vorrichtung sein, die mit Gleichstrom betrieben wird. In der Regel ist der Verbraucher jedoch ein Spannungswechselrichter, der die von der Photovoltaikvorrichtung erzeugte Gleichspannung in eine Wechselspannung umwandelt. Die Photovoltaikvorrichtung befindet sich normaler Weise auf dem Dach eines Gebäudes, wobei sich der Verbraucher in dem Gebäude befindet.

Erfindungsgemäß wird ein Steuersignal, das durch Modulation einer Spannung erzeugt werden kann, von einem Sender, der typische Weise im Gebäude angeordnet ist, über die Energie übertragenden Leitungen zu der Photovoltaikvorrichtung übermittelt. Das Steuersignal wird durch geeignete Mittel an der Photovoltaikvorrichtung empfangen und öffnet oder schließt eine Kurzschlussverbindung für den von der Photovoltaikvorrichtung erzeugten Stroms auf dem Dach des Gebäudes.

Durch das erfindungsgemäße Verfahren kann eine Photovoltaikvorrichtung sicher betrieben werden, ohne dass eine zusätzliche Signalleitung vorgesehen sein muss. Dies vereinfacht insbesondere das Nachrüsten von schon installierten Photovoltaikvorrichtungen mit Sicherheitsschaltungen. Die Photovoltaikvorrichtung kann zudem im Bedarfsfall in einen sicheren Kurzschlussbetrieb überführt werden, so dass keine gefährdenden Spannungen vorliegen.

Vorzugsweise wird zur Aufrechterhaltung des zweiten Betriebszustandes das Steuersignal permanent übermittelt. Auf diese Weise wird der von der Photovoltaikvorrichtung erzeugte Strom einem Verbraucher nur zugeführt, solange ein Steuersignal übermittelt wird. So wird beispielsweise während der Montage der Photovoltaikvorrichtung der von der Photovoltaikvorrichtung erzeugte Strom kurzgeschlossen, da noch kein Steuersignal zur Photovoltaikvorrichtung übertragen wird. Zudem kann durch einfaches Ausschalten eines Senders des Steuersignals die Photovoltaikvorrichtung in den sicheren zweiten Betriebszustand überführt werden. Die Schaltung ist daher sicherheitsgerichtet und geht immer in einen sicheren Zustand über, wenn keine definierten Betriebsbedingungen vorliegen.

Ferner ist es vorteilhaft, wenn das Steuersignal ausschließlich während des Betriebs des Verbrauchers übermittelt wird. Auf diese Weise wird der von der Photovoltaikvorrichtung erzeugte Strom einem Verbraucher nur bei Bedarf zugeführt. Dies hat insbesondere den Vorteil, dass bei einem Brand durch Abschalten der Stromversorgung der als Verbraucher bezeichnete Spannungswechselrichter abgestellt wird, aufgrund dessen die Photovoltaikvorrichtung in den ersten Betriebszustand überführt wird.

In Weiterbildung der Erfindung wird vorgeschlagen, dass das Steuersignal als gepulste periodische Modulation einer Signalspannung mit einer Frequenz von 10 kHz [Kilohertz] bis 500 kHz, bevorzugt 150 kHz bis 250 kHz, bei einem Puls-Pausen Verhältnis von 1:1 bis 1:50, bevorzugt 1:5 bis 1:15, übermittelt wird. Eine periodische Modulation kann beispielsweise ein Sinus-Signal, ein Rechtecksignal oder ein Dreiecksignal sein, das periodisch wiederkehrend übertragen wird. Dabei wird die Zeit, in der das periodische Signal übertragen wird, als Pulszeit und die Zeit zwischen zwei Pulsen als Pausenzeit aufgefasst. Es ist somit eine effiziente Signalübertragung über die Energie übertragenden Leitungen möglich, ohne dass sich Energieübertragung und Signalübertragung gegenseitig stören.

Ferner ist es vorteilhaft, wenn eine im ersten Betriebszustand vorliegende Restkurzschlussspannung möglichst niedrig gewählt werden kann. Da ein Kurzschlussschalter für seine Funktionsfähigkeit eine Mindeststeuerspannung benötigt, die höher sein kann als die Restkurzschlussspannung, ist es vorteilhaft, die Restkurzschlussspannung über eine geeignete Schaltung hochzusetzen und mit der hochgesetzten Spannung die Steuereinheit zu versorgen. Durch eine höhere an dem Kurzschlussschalter anliegende Steuerspannung wird die über den Kurzschlussschalter abfallende Kurzschlussspannung erniedrigt, so dass auch ein geringerer Strom durch den Schalter fließt und damit die in dem Element erzeugte Wärmeleistung geringer wird. Somit können einfache und kleine Schaltungselemente verwendet werden. Zudem wird durch eine niedrigere Restkurzschlussspannung, die auch an den Energie übertragenden Leitungen anliegt, bei einer Reihenschaltung mehrerer Photovoltaikvorrichtungen die Gefahr eines gesundheitsschädlichen Stromschlags verringert bzw. vermieden. Diese Maßnahme ist aber auch unabhängig von der vorliegenden Erfindung für die Versorgung einer Schaltung sinnvoll, wenn diese einer Photovoltaikvorrichtung direkt zugeordnet ist und die Schaltung z. B. von einer separaten Steuerleitung mit einem Steuersignal versorgt wird.

Einem weiteren Aspekt der Erfindung folgend wird eine Sicherheitsschaltung für eine Photovoltaikvorrichtung vorgeschlagen, umfassend Eingänge für den von der Photovoltaikvorrichtung erzeugten Strom, Ausgänge für den von der Photovoltaikvorrichtung erzeugten Strom zum Anschließen von Energie übertragenden Leitungen, einen Kurzschlussschalter geeignet zur steuerbaren Erzeugung eines Kurzschlusses des von der Photovoltaikvorrichtung erzeugten Stroms an den Eingängen und eine Steuereinheit zum Steuern des Kurzschlussschalters, wobei die Steuereinheit so ausgestaltet ist, dass der Steuereinheit ein Steuersignal von den Ausgängen für Energie übertragende Leitungen übermittelbar ist.

Eine solche Sicherheitsschaltung kann einem einzelnen Solarmodul zugeordnet sein oder aber auch einer Mehrzahl von zusammengeschalteten Solarmodulen. Die Eingänge der Sicherheitsschaltungen sind mit den Anschlüssen der Photovoltaikvorrichtung verbunden, so dass bei einer vorliegenden Bestrahlungsintensität eine Spannung zwischen den Eingängen anliegt. Über die Ausgänge der Sicherheitsschaltung wird der von der Photovoltaikvorrichtung erzeugte Strom über geeignete Kabel einem Verbraucher zugeführt. Die erfindungsgemäße Vorrichtung ist insbesondere geeignet und bestimmt zur Durchführung des erfindungsgemäßen Verfahrens.

Der Kurzschlussschalter ist bevorzugt ein Halbleiterbauelement, insbesondere ein MOSFET, das so beschaltet ist, dass ab einer an den Eingängen anliegenden Mindestspannung von beispielsweise 4 Volt die Eingänge der Sicherheitsschaltung kurzgeschlossen sind und somit ebenfalls der von der Photovoltaikvorrichtung erzeugte Strom. Die Steuereinheit ist dem Kurzschlussschalter so zugeschaltet, dass der Kurzschlussschalter bei Anliegen eines Steuersignals an der Steuereinhit den erzeugten Kurzschluss aufhebt, so dass einem Verbraucher der von der Photovoltaikvorrichtung erzeugte Strom zugeführt wird. Die Steuereinheit bestimmt somit den Zustand des Kurzschlussschalters aufgrund eines der Steuereinheit zuführbaren Steuersignals, welches insbesondere eine Spannungsmodulation aufweist. Erfindungsgemäß wird der Steuereinheit das Steuersignal von den Ausgängen der Sicherheitsschaltung ausgehend übertragen, so dass eine Steuersignalübertragung über die Energie übertragenen Leitungen möglich ist.

Mit einer solchen Sicherheitsschaltung, die der Photovoltaikvorrichtung auf dem Dach eines Gebäudes zugeordnet ist, kann die Photovoltaikvorrichtung ohne zusätzliche Signalleitungen und ohne zusätzliche Energieversorgung in einen sicheren Betriebszustand überführt werden. Dies reduziert zum einen das Gefährdungspotential bei der Montage der Photovoltaikvorrichtung und erlaubt das Überführen der Photovoltaikvorrichtung in einen sicheren Zustand im Bedarfsfall, beispielsweise bei einem Brand des Gebäudes.

Es ist vorteilhaft, wenn die Steuereinheit zumindest eines der folgenden Elemente umfasst:
- einen Filter,
- einen Steuersignaldemodulator,
- eine Ansteuerung.

Der Filter umfasst bevorzugt einen Serienschwingkreis aus einem Kondensator und einer Spule. Der Filter ist insbesondere geeignet, das an den Ausgängen der Photovoltaikvorrichtung anliegende Steuersignal aus der durch das Photovoltaikvorrichtung erzeugten Gleichspannung herauszufiltern bzw. zu verstärken. Der Steuersignaldemodulator ist bevorzugt als ein Spitzenwertgleichrichter aus einer Diode, einem Widerstand und einem Kondensator gebildet. Der Steuersignaldemodulator wird insbesondere dazu eingesetzt, dass von dem Filter ausgefilterte Steuersignal zu glätten und der Ansteuerung zuzuführen. Die Ansteuerung umfasst zumindest einen Transistor der dem Kurzschlussschalters ein Signal zuführen kann, so dass der Kurzschlussschalter den Kurzschluss an den Eingängen der Sicherheitsschaltung aufhebt.

Ferner ist es vorteilhaft, wenn eine Spannungserhöhungsvorrichtung zwischen mindestens einem der Eingänge und dem Kurzschlussschalter angeordnet ist. Eine solche Spannungserhöhungsvorrichtung kann auch unabhängig von der erfindungsgemäßen Sicherheitsschaltung mit einer Photovoltaikvorrichtung betrieben werden, die insbesondere mit einer separaten Steuerleitung zur Übertragung eines Steuersignals an die Steuereinheit betrieben wird. Die Spannungserhöhungsvorrichtung ist bevorzugt als Aufwärtswandler mit einer Spule, einer Diode und einem Kondensator realisiert. Die Spannungserhöhungsvorrichtung erlaubt es, die an dem Kurzschlussschalter anliegende Steuerspannung zur Versorgung des Kurzschlussschalters zu erhöhen, so dass die Restkurzschlussspannung, die im ersten Betriebszustand über dem Kurzschlussschalter abfällt, verringert wird. Im Kurzschlussbetrieb fällt daher nur eine geringe Wärmeleistung im Kurzschlussschalter an. Somit können einfache und kleine Schaltungselemente verwendet werden. Durch eine niedrigere Restkurzschlussspannung wird zudem bei einer Reihenschaltung mehrerer Photovoltaikvorrichtungen die Gefahr eines gesundheitsschädlichen Stromschlags verringert. In einer weiteren bevorzugten Ausführungsform der Spannungserhöhungsvorrichtung ist der Kurzschlussschalter selbst ein Element der Spannungserhöhungsvorrichtung. Dazu ist eine Induktivität in Reihe mit dem Kurzschlussschalter geschaltet. Durch kurzzeitiges Öffnen des Kurzschlussschalters wird genügend Energie bereitgestellt, um die am Kurzschlussschalter anliegende Steuerspannung zu erhöhen und so die Restkurzschlussspannung auf wenige mV (Millivolt) abzusenken. Der Kurzschlussschalter kann beispielsweise periodisch etwa alle 100 ms [Millisekunden] für 1 µs [Mikrosekunde] geöffnet werden. Das Tastverhältnis für das kurzzeitige Erzeugen der Steuerspannung kann in einem breiten Bereich gewählt werden. So ist es möglich, den Kurzschlussschalter die weitaus meiste Zeit voll durchzuschalten, so dass er nur eine geringe Verlustleistung aufnehmen muss, wobei gleichzeitig die Kurzschlussspannung am Ausgang sehr niedrig gehalten werden kann.

Bei einer weiteren Ausführungsform der Sicherheitsschaltung ist vorgesehen, dass die Ausgänge über Energie führende Kabel mit einem Verbraucher verbindbar sind und dem Verbraucher und/oder der Energie übertragenden Leitungen ein Steuersignalmodulator zuordenbar ist. Der Steuersignalmodulator erzeugt das Steuersignal, das über die Energie übertragenden Leitungen den Ausgängen der Sicherheitsschaltung übermittelt wird. Der Steuersignalmodulator ist dem Verbraucher bevorzugt so zugeordnet, dass er nur während des Betriebs des Verbrauchers ein Signal überträgt. Der Steuersignalmodulator kann aber auch so aufgebaut sein, dass der Steuersignalmodulator nur bei Vorliegen einer Netzspannung ein Signal überträgt. Auf diese Weise ist sichergestellt, dass nur beim Betrieb des Verbrauchers bzw. beim Vorliegen einer Netzspannung der von der Photovoltaikvorrichtung erzeugte Strom dem Verbraucher zugeführt wird. Wird der Verbraucher nicht betrieben bzw. liegt keine Netzspannung vor, so wird die Photovoltaikvorrichtung erfindungsgemäß kurzgeschlossen.

Um eine zuverlässige Steuersignalübertragung zu gewährleisten, ist es vorteilhaft, wenn der Steuersignalmodulator ausgelegt ist, eine Signalspannung mit einer Frequenz von 10 kHz bis 500 kHz bei einem Puls-Pausen Verhältnis von 1:1 bis 1:50 zu erzeugen.

Um eine effektive Steuersignalübertragung zu gewährleisten, ist es zudem vorteilhaft, wenn der Filter auf die von dem Steuersignalmodulator erzeugte Signalspannung abgestimmt ist. Damit ist insbesondere gemeint, dass die Resonanzfrequenz des Filters auf die Frequenz der Steuersignalspannung abgestimmt ist.

Die für das erfindungsgemäße Verfahren offenbarten Details und Vorteile lassen sich auf die erfindungsgemäße Vorrichtung übertragen und anwenden und umgekehrt. Die Erfindung sowie das technische Umfeld werden nachfolgend anhand der Figuren beispielhaft erläutert. Es ist darauf hinzuweisen, dass die Figuren bevorzugte Ausführungsvarianten der Erfindung zeigen, diese jedoch nicht darauf beschränkt ist. Es zeigen schematisch:
- Fig. 1:: eine erfindungsgemäße Sicherheitsschaltung 1,
- Fig. 2:: eine Solaranlage mit erfindungsgemäßer Sicherheitsschaltung 1, die einer Photovoltaikvorrichtung 2 zugeordnet ist und
- Fig. 3:: eine weitere Ausführungsform der erfindungsgemäßen Sicherheitsschaltung.

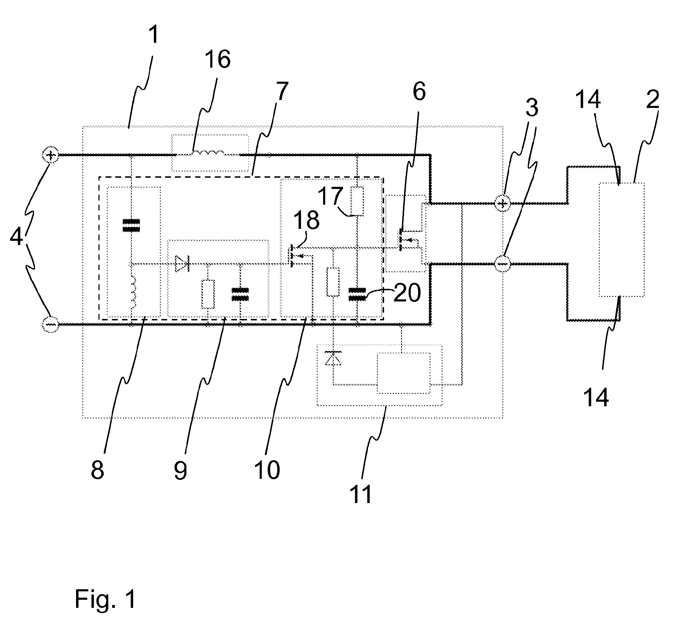

Fig. 1 zeigt schematisch eine Ausführungsform der erfindungsgemäßen Sicherheitsschaltung 1, die einer Photovoltaikvorrichtung 1 zugeordnet ist. Die Sicherheitsschaltung 1 umfasst Eingänge 3 zum Anschließen an Anschlüsse 14 der Photovoltaikvorrichtung 2 und Ausgänge 4 zum Anschließen von Energie übertragenden Leitungen 5. Die Sicherheitsschaltung 1 umfasst ferner einen Kurzschlussschalter 6, eine Steuereinheit 7, die einen Filter 8, einen Signaldemodulator 9 und eine Ansteuerung 10 aufweist, eine Spannungserhöhungsvorrichtung 11 und einen Entkoppler 16.

Im Betrieb liegt an den Eingängen 3 die von der Photovoltaikvorrichtung 2 erzeugte Spannung bzw. der von der Photovoltaikvorrichtung 2 erzeugte Strom an. Über einen ersten Widerstand 17 liegt diese Spannung an dem Kurzschlussschalter 6 an und bewirkt ein Kurzschließen der Eingänge 3 ab einer Spannung von weniger als 4 Volt. Der Kurzschlusszustand wird als erster Betriebszustand bezeichnet. Der Kurzschluss kann lediglich aufgehoben werden, wenn die über den ersten Widerstand abfallende Spannung über einen Schalter 18 kurzgeschlossen wird. Der Schalter 18 schließt die über den Widerstand 17 abfallende Spannung nur dann kurz, wenn an dem Eingang des Schalters 18 eine Spannung anliegt. An dem Eingang des Schalters 18 liegt allerdings nur eine Spannung an, wenn ein Steuersignal, beispielsweise eine gepulste periodische Modulation einer Signalspannung mit einer Frequenz von 10 kHz bis 500 kHz, an den Ausgängen 4 der Sicherheitsschaltung 1 anliegt. Es handelt sich somit um eine eigensichere Schaltung, die den Kurzschluss nur bei korrektem Betrieb der Sicherheitsschaltung aufhebt. Der Zustand, in dem Energie über die Ausgänge 4 abgeführt wird, wird als zweiter Betriebszustand bezeichnet.

Das Steuersignal wird durch den Filter 8, dessen Frequenz auf die Frequenz des Steuersignals abgestimmt ist, herausgefiltert bzw. verstärkt und dem Steuersignaldemodulator 9 zugeführt. Der Signaldemodulator 9 glättet das von dem Filter 8 herausgefilterte Steuersignal, so dass an dem Eingang des Schalters 18 permanent eine Spannung anliegt. Durch diese Schaltung wird lediglich bei Vorliegen eines Steuersignals der von der Photovoltaikvorrichtung 2 erzeugte Strom an die Ausgänge 4 und somit über Energie übertragene Leitungen 5 einem Verbraucher 12 zugeführt.

Die Spannungserhöhungsvorrichtung 11 kann die an den Eingängen 3 liegende, zur Versorgung der Ansteuerung 10 notwendige Spannung erhöhen, so dass der Kurzschlussschalter 6 schon bei Eingangsspannungen bzw. Kurzschlussspannungen von weniger als 1 Volt, insbesondere bei einigen Millivolt die Eingänge 3 kurzschließt. Durch die Erhöhung der an dem Kurzschlussschalter 6 anliegenden Steuerspannung wird nämlich gerade die über den Kurzschlussschalter 6 abfallende Kurzschlussspannung bis auf einige Millivolt verringert, was auch die Leistungsaufnahme dieses Bauteils entsprechend verringert. Der Entkoppler 16 verhindert, dass das Steuersignal durch den Kurzschlussschalter 6 kurzgeschlossen wird.

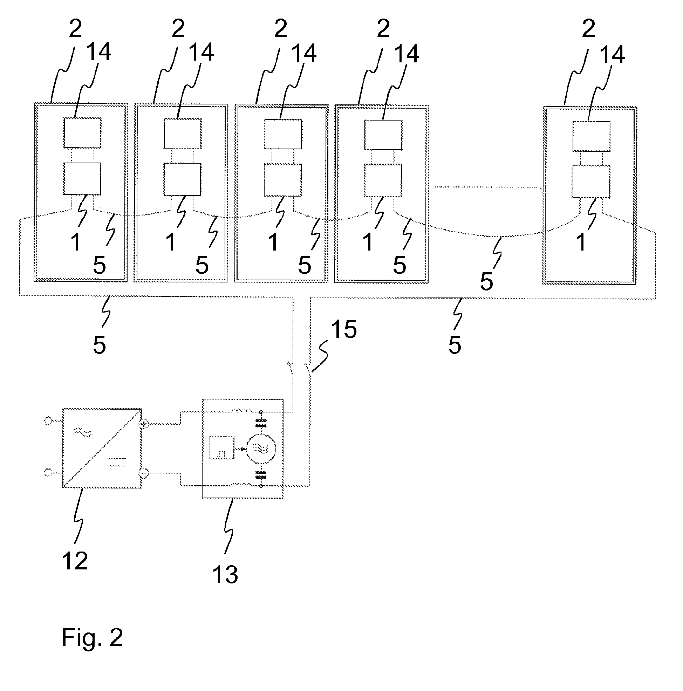

Figur 2 zeigt schematisch eine Solaranlage mit einer Mehrzahl von in Reihe geschalteten Photovoltaikvorrichtungen 2. Die Photovoltaikvorrichtungen 2 umfassen Anschlüsse 14, über die die Photovoltaikvorrichtungen 2 mit einer erfindungsgemäßen Sicherheitsschaltung 1 verbunden sind. Die Photovoltaikvorrichtungen 2 sind über Energie übertragende Leitungen 5 in Reihe geschaltet und mit einem Signalmodulator 13 und einem Verbraucher 12 verbunden. Der Verbraucher 12 ist als Spannungswechselrichter ausgeführt, der den von den Photovoltaikvorrichtungen 2 erzeugten Gleichstrom in Wechselstrom umwandelt. In den zu dem Verbraucher 12 führenden Energie übertragenen Leitungen 5 ist zudem ein Trennschalter 15 angeordnet.

Im Betrieb wird der von den Photovoltaikvorrichtungen 2 erzeugte Strom dem Verbraucher 12 zugeführt, solange den erfindungsgemäßen Sicherheitsschaltungen 1 über die Energie übertragenen Leitungen 5 ein Steuersignal zugeführt wird. Das Steuersignal wird von dem Signalmodulator 13 erzeugt. Wird der Signalmodulator über den Trennschalter 15 von den erfindungsgemäßen Sicherheitsschaltungen 1 getrennt, so werden die Photovoltaikvorrichtungen 2 jeweils kurzgeschlossen. Auf diese Weise kann keine bedrohliche Spannung außerhalb der Photovoltaikvorrichtungen 2 anliegen. Besonders sicher ist natürlich eine Photovoltaikvorrichtung, bei der die Sicherheitsschaltung so integriert ist, dass nur gesicherte Ausgänge von außen zugänglich sind.

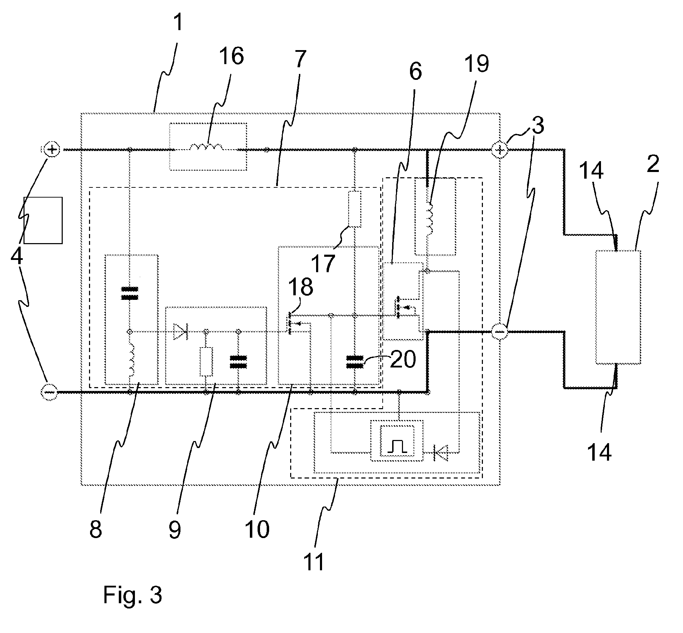

Fig. 3 zeigt schematisch eine weitere Ausführungsform der erfindungsgemäßen Sicherheitsschaltung 1, wobei im Folgenden nur auf die Unterschiede zu der Ausführungsform gemäß Fig. 1 eingegangen wird. In der Ausführungsform gemäß Fig. 3 ist der Kurzschlussschalter 6 selbst Element der Spannungserhöhungsvorrichtung 11, wobei eine Induktivität 19 zu dem Kurzschlussschalter 6 in Reihe geschaltet ist. Durch kurzzeitiges, periodisches Öffnen des Kurzschlussschalters 6 wird der Sicherheitsschaltung 1 genügend Energie zur Verfügung gestellt, um die am Kurzschlussschalter 6 anliegende Steuerspannung zu erhöhen und somit eine Restkurzschlussspannung, die im ersten Betriebszustand über dem Kurzschlussschalter 6 abfällt und an den Ausgängen 4 anliegt bis auf einige mV zu erniedrigen. Die zur Aufrechterhaltung der Spannung notwendige Energie ist in einem Kondensator 20 der Steuereinheit 7 gespeichert und wird durch das kurzzeitige Öffnen des Kurzschlussschalters 6 jeweils nachgeladen. Der Kurzschlussschalter 6 wird beispielsweise durch die Spannungserhöhungsvorrichtung 11 alle 100 ms für 1 µs geöffnet, wodurch die in Induktivität 19 gespeicherte magnetische Energie zur Aufladung des Kondensators 20 genutzt werden kann. Im Ergebnis können einfachere und kleinere Bauelemente für die Kurzschlussschaltung verwendet werden und es liegt selbst bei Reihenschaltung einer Vielzahl von Solarmodulen eine Spannung von lediglich einigen mV im ersten Betriebszustand an.

Durch die Erfindung ist es möglich, ohne eine zusätzliche Steuerleitung Photovoltaikvorrichtungen 2 bei Bedarf kurzzuschließen, um die

Photovoltaikvorrichtungen in einen sicheren Zustand zu überführen. Die erfindungsgemäße Sicherheitsschaltung 1 sorgt zudem dafür, dass wegen der geringen erforderlichen Leistung bei Kurzschluss einfache und kleine Elektronikbauelemente verwendet werden können und dass während der Montage keine gefährlichen Spannungen vorliegen. Die Erfindung ermöglicht somit jederzeit eine sichere Handhabung von Photovoltaikvorrichtungen.

### Bezugszeichenliste

- 1: Sicherheitsschaltung
- 2: Photovoltaikvorrichtung
- 3: Eingang
- 4: Ausgang
- 5: Energie übertragende Leitung
- 6: Kurzschlussschalter
- 7: Steuereinheit
- 8: Filter
- 9: Signaldemodulator
- 10: Ansteuerung
- 11: Spannungserhöhungsvorrichtung
- 12: Verbraucher
- 13: Signalmodulator
- 14: Anschlüsse
- 15: Trennschalter
- 16: Entkoppler
- 17: Widerstand
- 18: Schalter
- 19: Induktivität
- 20: Kondensator

## Patentansprüche

1. Verfahren zum Betreiben einer Photovoltaikvorrichtung (2), wobei in einem ersten Betriebszustand der von der Photovoltaikvorrichtung (2) erzeugte Strom kurzgeschlossen wird und in einem zweiten Betriebszustand der von der Photovoltaikvorrichtung (2) erzeugte Strom über Energie übertragende Leitungen (5) einem Verbraucher (12) zugeführt wird, **dadurch gekennzeichnet, dass** ein Steuersignal zur Steuerung des Betriebszustandes über die Energie übertragenden Leitungen (5) übermittelt wird.

2. Verfahren nach Anspruch 1, wobei zur Aufrechterhaltung des zweiten Betriebszustands das Steuersignal permanent übermittelt wird.

3. Verfahren nach Anspruch 1 oder 2, wobei das Steuersignal ausschließlich während des Betriebs des Verbrauchers (12) übermittelt wird.

4. Verfahren nach einem der vorhergehenden Ansprüche, wobei das Steuersignal als gepulste periodische Modulation einer Signalspannung mit einer Frequenz von 10 kHz bis 500 kHz bei einem Puls-Pausen Verhältnis von 1:1 bis 1:50 übermittelt wird.

5. Verfahren nach einem der vorhergehenden Ansprüche, wobei eine im ersten Betriebszustand vorliegende Restkurzschlussspannung an den Energie übertragenden Leitungen (5) möglichst gering gewählt wird, vorzugsweise im Bereich von 1 mV, und gleichzeitig ein Hochsetzen der Restkurzschlussspannung zur Versorgung einer für die Steuerung des Betriebszustandes erforderlichen Steuereinheit (7) erfolgt.

6. Sicherheitsschaltung (1) für eine Photovoltaikvorrichtung (2), umfassend Eingänge (3) für den von der Photovoltaikvorrichtung (2) erzeugten Strom, Ausgänge (4) für den von der Photovoltaikvorrichtung (2) erzeugten Strom zum Anschließen von Energie übertragenden Leitungen (5), einen Kurzschlussschalter (6) geeignet zur steuerbaren Erzeugung eines Kurzschlusses des von der Photovoltaikvorrichtung (2) erzeugten Stroms an den Eingängen (3) und eine Steuereinheit (7) zum Steuern des Kurzschlussschalters (6), **dadurch gekennzeichnet, dass** die Steuereinheit (7) so ausgestaltet ist, dass der Steuereinheit (7) ein Steuersignal von den Ausgängen (4) für Energie übertragende Leitungen (5) übermittelbar ist.

7. Sicherheitsschaltung (1) nach Anspruch 6, **dadurch gekennzeichnet, dass** die Steuereinheit (7) zusätzlich zumindest eines der folgenden Elemente umfasst:
- einen Filter (8),
- einen Steuersignaldemodulator (9),
- eine Ansteuerung (10).

8. Sicherheitsschaltung (1) nach Anspruch 6 oder 7, **dadurch gekennzeichnet, dass** eine Spannungserhöhungsvorrichtung (11) zwischen mindestens einem der Eingänge (3) und der Steuereinheit (7) angeordnet ist.

9. Sicherheitsschaltung (1) nach einem der Ansprüche 6 bis 8, wobei die Ausgänge (4) über Energie führende Kabel (5) mit einem Verbraucher (12) verbindbar sind, **dadurch gekennzeichnet, dass** dem Verbraucher (12) und/oder den Energie übertragenden Leitungen (5) ein Steuersignalmodulator (13) zuordenbar ist.

10. Sicherheitsschaltung (1) nach Anspruch 9, wobei der Steuersignalmodulator (13) ausgelegt ist, eine Signalspannung mit einer Frequenz von 10 kHz bis 500 kHz bei einem Puls-Pausen Verhältnis von 1:1 bis 1:50 zu erzeugen und wobei vorzugsweise der Filter (8) auf die von dem Steuersignalmodulator (13) erzeugte Signalfrequenz abgestimmt ist.
